# EUROPÄISCHE PATENTSCHRIFT

(11) **EP 1 636 854 B1**
(45) Veröffentlichungstag und Bekanntmachung des Hinweises auf die Patenterteilung: **02.08.2006**
(21) Anmeldenummer: 04738601.6
(22) Anmeldetag: 04.06.2004
(51) Int. Cl.: H01L 31/0203, H01L 23/538

(54) **SENSORBAUTEIL UND NUTZEN ZU SEINER HERSTELLUNG**
SENSOR COMPONENT, AND PANEL USED FOR THE PRODUCTION THEREOF
CAPTEUR ET PLAQUETTE POUR LA FABRICATION DUDIT CAPTEUR

(30) Priorität: 23.06.2003 DE 10328265
(43) Veröffentlichungstag der Anmeldung: 22.03.2006
(73) Patentinhaber: Infineon Technologies AG, 81669 München (DE)
(72) Erfinder: FÜRGUT, Edward, 86453 Dasing (DE); GOLLER, Bernd, 83624 Otterfing (DE); HAGEN, Robert-Christian, 93092 Sarching (DE); JEREBIC, Simon, 93049 Regensburg (DE); POHL, Jens, 93170 Bernhardswald (DE); STROBEL, Peter, 93047 Regensburg (DE); WÖRNER, Holger, 93049 Regensburg (DE)
(74) Vertreter: Schäfer, Horst
(86) Internationale Anmeldenummer: PCT/DE2004/001147
(87) Internationale Veröffentlichungsnummer: WO 2005/001942

(56) Entgegenhaltungen:
- EP-A- 0 611 129
- EP-A- 0 802 030
- WO-A-01/17033
- US-A- 6 001 671
- US-B1- 6 399 418
- US-B1- 6 468 832
- FILLION R ET AL: "Development of a plastic encapsulated multichip technology for high volume, low cost commercial electronics" PROCEEDINGS OF THE ELECTRONIC COMPONENTS AND TECHNOLOGY CONFERENCE. WASHINGTON, MAY 1 - 4, 1994, NEW YORK, IEEE, US, Bd. CONF. 44, 1. Mai 1994 (1994-05-01), Seiten 805-809, XP010126278 ISBN: 0-7803-0914-6

## Beschreibung

Die Erfindung betrifft ein Sensorbauteil und einen Nutzen mit mehreren Sensorbauteilpositionen, wobei in den Positionen Sensorchips mit Sensorbereichen und mit Kontaktflächen auf ihren aktiven Oberseiten angeordnet sind.

Die Sensorchips derartiger Sensorbauteile sind bisher auf einem Schaltungssubstrat beziehungsweise auf einem Nutzen in Form einer Leiterplatte mit mehreren Sensorbauteilpositionen angeordnet. Eine derartige Anordnung bedingt, dass zum Schaltungssubstrat beziehungsweise zum Nutzen, hin in jeder der Sensorbauteilpositionen Verbindungen von den Kontaktflächen zu Kontaktanschlussflächen auf dem Schaltungssubstrat herzustellen sind. Diese Verbindungen werden mit zeitaufwendigen und kostenintensiven, sowie thermisch belastenden Verbindungstechniken geschaffen, was die Zuverlässigkeit des Sensorbauteils einschränkt und gleichzeitig hohe Kosten verursacht.

Aus der EP-A-0 611 129 ist bekannt, elektrische Halbleiter bauelemente in einen Kunststoffkörper einzubetten und von der freibleidenden Seite, die mit der Oberseite des Kunststoffkörpers eine Ebene bildet, über darauf aufgebrachte Kontakte elektrisch zu verbinden, wobei die nicht eingebettete Seite der Halbleiterbauelemente durch die Verdrahtung verdeckt ist.

Ein in einen Kunststoffkörper eingebetteter Sensorchip ist aus der WO-A-01/17033 bekannt, allerdings besteht hier ein vertikaler Abstand swischen der Verdrahtungsebene auf der Oberfläche des Kunststoffkörpers und der Kontaktfläche des Sensorchips.

Aufgabe der Erfindung ist es, ein Sensorbauteil zu schaffen, das eine verbesserte Zuverlässigkeit aufweist und kostengünstiger herstellbar ist.

Gelöst wird diese Aufgabe mit dem Gegenstand der unabhängigen Anspruche 1 und 10. Vorteilhafte Weiterbildungen der Erfindung ergeben sich aus den abhängigen Ansprüchen.

Erfindungsgemäß wird ein Sensorbauteil angegeben, das einen Sensorchip mit einem Sensorbereich auf seiner aktiven Oberseite aufweist. Die Elektroden des Sensorbereichs sind über

Leiterbahnen mit Kontaktflächen auf der aktiven Oberseite des Sensorchips verbunden. Der Sensorchip ist mit seiner Rückseite und mit seinen Randseiten in eine Kunststoffplatte eingebettet, wobei die aktive Oberseite des Sensorchips mit einer Oberseite der Kunststoffplatte eine Gesamtoberseite bildet. Auf dieser Gesamtoberseite ist eine Umverdrahtungslage mit einer Umverdrahtungsschicht angeordnet, wobei sich die Umverdrahtungsleitungen von den Kontaktflächen zu Außenkontaktflächen des Sensorbauteils erstrecken.

Ein derartiges Sensorbauteil hat den Vorteil, dass für die elektrischen Verbindungen zwischen Sensorchip und Kunststoffplatte keine Niveausprünge zu überwinden sind, sondern die Umverdrahtungslage mit ihren Umverdrahtungsleitungen auf einer Gesamtoberseite angeordnet ist. Folglich entfallen komplexe Verbindungstechniken, wie Bondtechnik oder Flip-Chip-Technik. Außerdem können mit dem Sensorchip beliebig viele Halbleiterchips und passive Bauelemente zu einem Sensormodul in die Kunststoffplatte eingebettet werden. Dazu sind in die Gesamtoberseite Elektrodenflächen, von in die Kunststoffplatte eingebetteten passiven Bauelementen, vorgesehen. In diesem Fall verbinden die Umverdrahtungsleitungen auf der Gesamtoberseite Elektrodenflächen der passiven Bauelemente mit Kontaktflächen des Sensorchips und/oder des Halbleiterchips und/oder mit Außenkontaktflächen.

Eine derartige Verdrahtung mit Hilfe von Umverdrahtungsleitungen erfolgt innerhalb einer einzigen Umverdrahtungschicht. Diese Umverdrahtungsschicht kann durch weitere Isolationsschichten und Umverdrahtungsschichten erweitert werden, wobei mehrere Umverdrahtungsschichten über Durchkontakte durch die Isolationsschichten miteinander verbunden sind. Damit ergibt sich eine mehrschichtige Umverdrahtungslage, die ohne großen Aufwand auf die Gesamtoberseite aus Halbleiteroberseiten und Kunststoffoberseite gebildet wird.

Anstelle einer Anordnung von Sensorchip und Halbleiterchip nebeneinander ist es auch möglich, in der Kunststoffplatte eine Stapelung eines Sensorchips mit einem Halbleiterchip übereinander unterzubringen. Dieses hat den Vorteil, dass die Gesamtoberseite des Sensorbauteils klein gehalten werden kann.

Der Sensorbereich kann auf Druck, Temperatur, Wärmestrahlung oder elektromagnetische Strahlung reagieren.

In einer weiteren Ausführungsform der Erfindung wird über dem Sensorbereich eine Linse angeordnet, um eine höhere optische Empfindlichkeit zu erreichen. Diese Linse kann aus Glas bestehen oder eine flache Linsenfolie mit Fresnelringen aufweisen, was den Vorteil hat, dass sich die Höhe des Sensorbauteils durch Anbringen einer Fresnellinse nicht wesentlich vergrößert.

Außerhalb des Bereichs des Sensorchips kann die Kunststoffmasse in einer weiteren Ausführungsform der Erfindung Durchkontakte zu Außenkontaktflächen aufzuweisen, die der Gesamtoberseite gegenüber liegen. Das hat den Vorteil, dass der Sensorbereich frei zugänglich ist, selbst wenn das Sensorbauteil auf einer Leiterplatte mit Hilfe der Außenkontakte fixiert wird. Im anderen Fall, das heißt, wenn keine Durchkontakte durch die Kunststoffmasse vorgesehen sind, und die Außenkontakte auf der gleichen Oberseite, das heißt auf der gemeinsamen Gesamtoberseite angeordnet sind, wäre es erforderlich, in einer darüber angeordneten Leiterplatte eine Öffnung vorzusehen, so dass ein Zugriff zu dem Sensorbereich des Sensorchips möglich wird. Die Durchkontakte zu den Außenkontaktflächen können auf der Gesamtoberseite elektrisch über Umverdrahtungsleitungen mit den Kontaktflächen des Sensorchips verbunden sein.

Ein weiterer Aspekt der Erfindung betrifft ein optoelektronisches Gerät, das ein Sensorbauteil aufweist, welches in einem Kameragehäuse untergebracht ist. Der Sensorbereich des Halbleiterchips weist in diesem Falle eine CCD-Struktur oder eine andere Bildaufnahmestruktur auf, mit der beispielsweise Bilder mittels eines Handy's aufgenommen werden können und zu einem Gesprächspartner übertragen werden können.

Das Sensorbauteil kann auch einen Zusatz aufweisen, so dass es als optoelektronisches Kopplungsbauteil eingesetzt werden kann. In diesem Fall wird über dem Sensorbereich ein Glasfasereinsteckbereich angeordnet, in dem eine Glasfaser als Lichtwellenleiter einsteckbar ist. Derartige optoelektronische Kopplungsbauteile werden in großen Mengen benötigt, so dass die kostengünstige Herstellung des erfindungsgemäßen Sensorbauteils von Vorteil ist.

Ein weiterer Aspekt der Erfindung bezieht sich auf einen Nutzen, der in Zeilen und Spalten angeordnete Bauteilpositionen für Sensorbauteile aufweist. Dabei weist der Nutzen bereits alle Schaltungskomponenten des Sensorbauteils auf, wie Sensorchip mit Sensorbereich und mit Kontaktflächen, Oberseiten von Halbleiterchips mit Kontaktflächen, Elektroden von passiven Bandelementen, eine Kunststoffoberseite, welche die Halbleiterchipoberseiten umgibt, eine Umverdrahtungslage auf einer Gesamtoberseite. Dabei weist die Umverdrahtungslage eine Umverdrahtungsschicht mit Umverdrahtungsleitungen auf, welche die Kontaktflächen der Sensorchips mit Außenkontaktflächen des Sensorbauteils verbindet. Auf der Gesamtoberseite des Nutzen können auch noch Außenkontakte auf den Außenkontaktflächen angeordnet werden, um in jeder der Bauteilpositionen ein Sensorbauteil zu komplettieren, bevor der Nutzen in Einzelbauteile getrennt wird.

Ein Verfahren zur Herstellung eines Nutzens weist die nachfolgenden Verfahrensschritte auf. Zunächst wird ein Halbleiterwafer bereitgestellt, der in Zeilen und Spalten angeordnete Sensorchippositionen aufweist. Anschließend wird der Halbleiterwafer in einzelne Sensorchips mit einem Sensorbereich und Kontaktflächen auf einer aktiven Oberseite der Sensorchips getrennt. Danach wird eine Klebefolie oder eine Klebeplatte in eine erste Moldwerkzeughälfte mit in Zeilen und Spalten angeordneten Bauteilpositionen eingelegt. Auf die Bauteilpositionen der Klebefolie beziehungsweise der Klebeplatte wird dann jeweils ein Sensorchip des Halbleiterwafers in den Bauteilpositionen unter Aufkleben der aktiven Oberseite der Sensorchips auf die Klebeseite der Klebefolie beziehungsweise der Klebeplatte aufgebracht.

Danach werden die Moldwerkzeughälften zusammengefahren und eine Kunststoffmasse in die Form unter einseitigem Einbetten der Sensorchips eingespritzt. Nach einem Aushärten der Kunststoffmasse zu einer Verbundplatte aus Kunststoffmasse und Sensorchips werden die Moldwerkzeughälften auseinandergefahren und die Verbundplatte entnommen. Schließlich wird die Klebefolie beziehungsweise die Klebeplatte von der Verbundplatte entfernt und eine Umverdrahtungslage auf die freigewordene Gesamtoberseite der Verbundplatte aufgebracht.

Dieses Verfahren hat den Vorteil, dass nach dem Spritzgießen der Verbundplatte eine gemeinsame Gesamtoberseite zum Aufbringen von weiteren Beschichtungen gleichzeitig für mehrere Sensorbauteile zur Verfügung steht. Darüber hinaus hat das Verfahren den Vorteil, dass weder eine Stufe zwischen der aktiven Oberseite des Sensorchips und der Kunststoffmasse noch ein Abstand zwischen der aktiven Oberseite des Sensorchips und der Kunststoffmasse auftritt, so dass mit einer einzigen Umverdrahtungsschicht das gesamte Sensorbauteil verdrahtet werden kann. Diese Umverdrahtungsschicht der Umverdrahtungslage weist Umverdrahtungsleitungen auf, welche die Kontaktflächen des Sensorchips mit Außenkontaktflächen des Sensorbauteils verbinden. Ferner können auf diese Außenkontaktflächen noch im Zustand des Nutzens Außenkontakte in Form von Lothöckern oder Lotbällen oder Außenkontaktflecken aufgebracht werden.

Bei einem weiteren Durchführungsbeispiel des Verfahrens werden auf die Klebefolie oder Klebeplatte Elektroden von passiven Bauteilen mit aufgebracht, so dass eine komplexere Sensorschaltung für das Sensorbauteil realisiert werden kann. Darüber hinaus ist es auch möglich, in den Bauteilpositionen zusätzliche Halbleiterchips mit integrierten Schaltungen zu positionieren, und zwar jeweils mit ihren Kontaktflächen auf der Klebefolie beziehungsweise Klebeplatte, damit beim Abziehen der Klebefolie oder Klebeplatte die Kontaktflächen der zusätzlich integrierten Schaltungen durch Umverdrahtungsleitungen kontaktiert werden können.

Somit ermöglicht dieses Verfahren auf einfachste Weise, komplexe Sensorbauteile aufzubauen, wobei zur Erstellung des kartenförmigen Gehäuses lediglich ein Gießschritt erforderlich ist und für die Verbindung der einzelnen Schaltungskomponenten in Form von passiven Bauteilen und integrierten Schaltungselementen und Sensorchips lediglich eine strukturierte Umverdrahtungsschicht erforderlich wird. Sollten der Sensorchip und ein Halbleiterchip mit integrierter Schaltung übereinander gestapelt werden, so ist eine interne Stapelverdrahtung vor einem Einbetten in die gemeinsame Kunststoffplatte durchzuführen und/oder eine Überhöhung der Kontaktflächen des unteren Halbleiterchip erforderlich, um diese auf der Gesamtoberseite mit anderen Komponenten des Sensorbauteils zu verdrahten.

Ein Verfahren zur Herstellung eines Sensorbauteils weist den zusätzlichen Verfahrensschritt auf, dass nach dem Herstellen eines Nutzens noch Außenkontakte auf die Außenkontaktflächen aufgebracht werden und anschließend der Nutzen in einzelne Sensorbauteile getrennt wird.

Zusammenfassend ist festzustellen, dass mit der Erfindung ein preiswertes, platzsparendes Gehäuse erzeugt wird, welches zudem eine gute Charakteristik bezüglich Feuchtigkeitsempfindlichkeit aufweist. Dies wird dadurch erreicht, dass das Gehäuse in Anlehnung an eine sogenannte "Universal Package"-Technologie aufgebaut ist. Anders als bei der Montage von normalen, nicht optischen Halbleitern werden bei den optoelektronischen Komponenten die Sensorflächen nicht durch Dielektrika beziehungsweise Lötstopplacke abgedeckt, sondern zur späteren Abdeckung mit optischen Materialien beziehungsweise optischen Bauelementen, zum Beispiel Linsen, freigelassen. Zusammenfassend ergeben sich damit folgende Vorteile:
1. Geringe Herstellungskosten des Gehäuses;
2. Geringer Platzbedarf des Gehäuses, wie es beispielsweise für Handy-Kameras erforderlich wird;
3. Eine Oberflächenmontage des Gehäuses ist aufgrund der geringen Feuchteempfindlichkeit möglich, das bedeutet, das erfindungsgemäße Bauteil kann in normalen oberflächenmontierenden Prozessen auf eine Platine eines übergeordneten Schaltkreises problemlos aufgelötet werden.

Die Erfindung wird nun anhand der beigefügten Figuren näher erläutert.
- Figur 1: zeigt eine schematische perspektivische Ansicht eines Sensorbauteils einer ersten Ausführungsform der Erfindung,
- Figur 2: zeigt einen schematischen Querschnitt durch ein Sensorbauteil gemäß in einem Gehäuse einer zweiten Ausführungsform der Erfindung,
- Figur 3: zeigt einen schematischen Querschnitt durch ein Sensorbauteil als Kopplungsbauteil gemäß einer dritten Ausführungsform der Erfindung,
- Figur 4: zeigt einen schematischen Querschnitt durch eine Sensorbauteilposition eines Nutzens vor dem Aufbringen von Außenkontakten,
- Figur 5: zeigt einen schematischen Querschnitt durch ein Sensorbauteil nach Aufbringen einer Linse auf einen Sensorbereich des Bauteils als vierte Ausführungsform der Erfindung,
- Figur 6: zeigt einen schematischen Querschnitt durch ein Sensorbauteil gemäß einer fünften Ausführungsform der Erfindung,
- Figur 7: zeigt einen schematischen Querschnitt durch ein Sensorbauteil gemäß einer sechsten Ausführungsform der Erfindung,
- Figur 8: zeigt einen schematischen Querschnitt durch ein Sensorbauteil gemäß einer siebten Ausfführungsform der Erfindung.

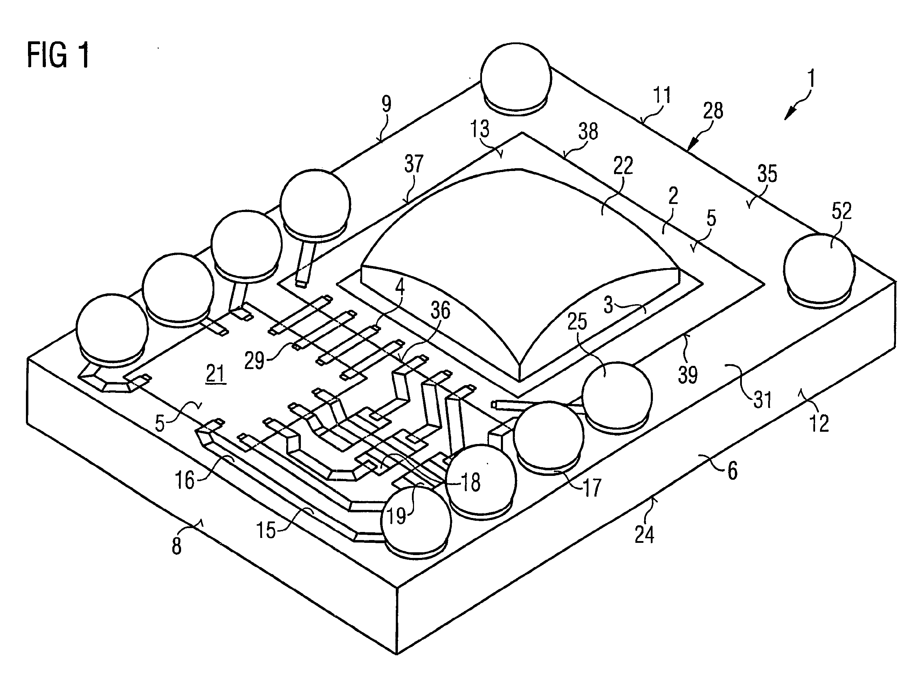

Figur 1 zeigt eine schematische perspektivische Ansicht eines Sensorbauteils 1 einer ersten Ausführungsform der Erfindung. Ein Sensorchip 2 ist mit seinen Randseiten 36, 37, 38 und 39 in eine Kunststoffplatte 6 mit den Randseiten 8, 9, 11 und 12 eingebettet. Eine aktive Oberseite 5 des Sensorchips 2 und eine Oberseite 35 der Kunststoffplatte 6 bilden eine Gesamtoberseite 13. Zusätzlich zu der aktiven Oberseite 5 des Sensorchips 2 umfaßt die Gesamtoberseite 13 eine aktive Oberseite eines zusätzlichen Halbleiterchips 21, auf welcher Kontaktflächen 29 angeordnet sind. Darüber hinaus sind auf der Gesamtoberseite 13 die Elektrodenflächen 18 von drei passiven Bauelementen 19 angeordnet.

Neben den Kontaktflächen 4 und 29 beziehungsweise des sowohl des Sensorchips 2 als auch des Halbleiterchips 21 und den Elektroden 18 der passiven Bauelemente 19 weist die Gesamtoberseite Außenkontaktflächen 17 auf, auf denen Außenkontakte 25 angeordnet sind.

Auf der Gesamtoberseite 13 ist eine Umverdrahtungsschicht 15 angeordnet, die mit ihren Umverdrahtungsleitungen 16 Kontaktflächen 4 des Sensorchips 2 mit Kontaktflächen 29 des Halbleiterchips 21 verbindet und Kontaktflächen 4 mit Elektrodenflächen 18 verbindet, sowie über weitere Umverdrahtungsleitungen 16 die Kontaktflächen 4 und 29 als auch die Elektrodenflächen 18 mit Außenkontaktflächen 17 auf der Gesamtoberseite 13 verbindet. Das in Figur 1 gezeigte Sensorbauteil 1 stellt somit bereits ein Sensormodul dar und kann über die Außenkontakte 25 mit einer übergeordneten Schaltung auf einer Leiterplatine verbunden werden. Bei einer derartigen Oberflächenmontage eines Sensorbauteils der ersten Ausführungsform der Erfindung, wie es Figur 1 zeigt, ist in der übergeordneten Schaltungsplatine eine Öffnung vorzusehen, die dem Sensorbereich 3 des Sensorchips 2 entspricht, um einen Zugriff auf dem Sensorbereich 3 zu ermöglichen.

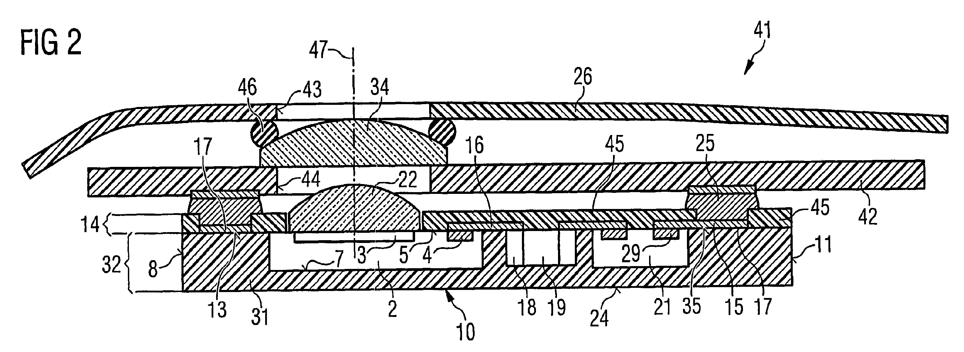

Figur 2 zeigt einen schematischen Querschnitt durch ein Sensorbauteil 10 in einem Kameragehäuse 26 gemäß einer zweiten Ausführungsform der Erfindung. Komponenten mit gleichen Funktionen wie in Figur 1 werden mit gleichen Bezugszeichen gekennzeichnet und nicht extra erörtert.

Das Sensorbauteil 10 ist ein Teil eines Kamerabauteils 41, und auf einer übergeordneten Schaltungsplatine 42 in dem Kameragehäuse 26 eines Mobiltelefons angeordnet. Die drei Komponenten, Systembauteil 10, Schaltungsplatine 42 und Kameragehäuse 26 sind übereinander angeordnet, wobei das Sensorbauteil 10 unterhalb der übergeordneten Schaltungsplatine 42 und die Schaltungsplatine 42 unterhalb des Kameragehäuses 26 angeordnet sind. Das Sensorbauteil 10 weist einen Sensorchip 2, einen Halbleiterchip 21 und passive Bauelemente 19 auf. Der Sensorchip 2 weist eine aktive Oberseite 5 mit einem Sensorbereich 3 und Kontaktflächen 4 und eine Rückseite 7 auf. Der Halbleiterchip 21 weist Kontaktflächen 29 auf, und das passive Bauelement 19 weist Elektrodenflächen 18 auf.

Der Sensorchip 2, der Halbleiterchip 21 und die passiven Bauelemente 19 sind derart in eine Kunststoffmasse 31 eingebettet, dass sie eine Kunststoffplatte 6 bilden, die eine Gesamtoberseite 13 mit dem Sensorbereich 3, den Kontaktflächen 4 und 29 und den Elektrodenflächen 18 aufweist. Auf dieser Gesamtoberseite 13 sind Umverdrahtungsleitungen 16 angeordnet, welche die Schaltungselemente 2, 19 und 21 untereinander verbinden und elektrische Verbindungen zu Außenkontaktflächen 17 herstellen. Auf den Außenkontaktflächen 17 sind Außenkontakte 25 angeordnet, die an die übergeordnete Schaltungsplatine 42 angelötet sind.

Die Umverdrahtungsleitungen 16 bilden eine Umverdrahtungsschicht 15, die Teil einer Umverdrahtungslage 14 ist, wobei die Umverdrahtungslage 14 zusätzlich eine isolierende Abdeckschicht 45 aufweist, die lediglich den Sensorbereich 3 und die Außenkontaktflächen 17 freilässt. Der Sensorbereich 3 trägt eine Linse 22, die zu der optischen Achse 47 einer zweiten Linse 34 ausgerichtet ist, wobei die zweite Linse 34 zwischen Kameragehäuse 26 und übergeordneter Schaltungsplatine 42 ausgerichtet ist.

Die übergeordnete Schaltungsplatine 42 und das Kameragehäuse 26 weisen Öffnungen 43 beziehungsweise 44 auf, deren Größe dem Sensorbereich 3 des Sensorchips 2 entspricht, so dass der optische Eindruck der Umgebung auf den Sensorbereich 3 des Sensorchips 2 über die Linsen 34 und 22 einwirken kann. Ein Dichtungselement 46 zwischen der zweiten Linse 34 und dem Kameragehäuse 26 sorgt dafür, dass keine Feuchtigkeit und keine Staubpartikel in das Gehäuse 26 eindringen können.

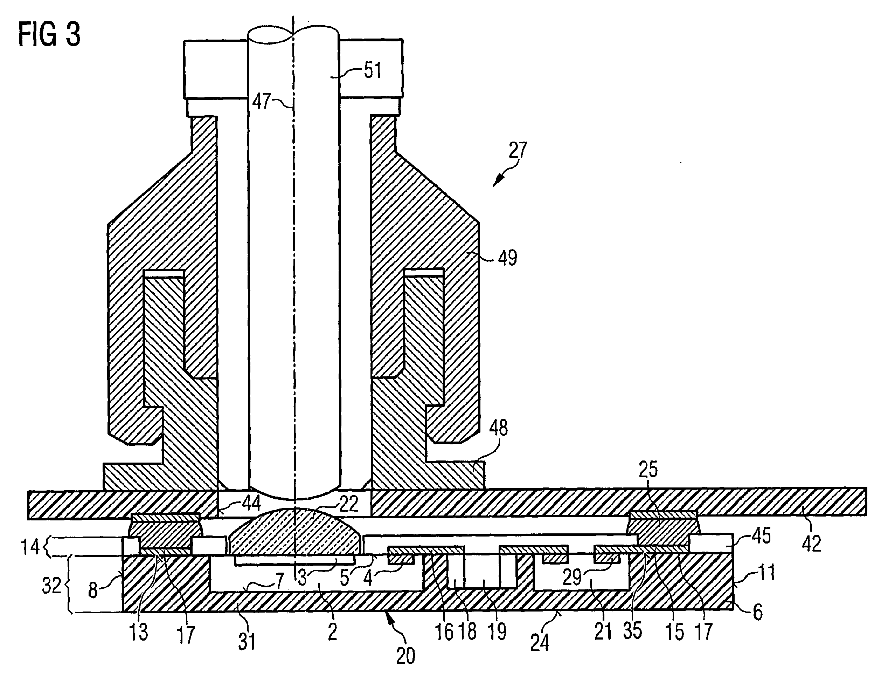

Figur 3 zeigt einen schematischen Querschnitt durch ein Sensorbauteil 20, das als Kopplungsbauteil gemäß einer dritten Ausführungsform der Erfindung ausgebildet ist. Komponenten mit gleichen Funktionen wie in den vorhergehenden Figuren werden mit gleichen Bezugszeichen gekennzeichnet und nicht extra erörtert.

Das Sensorbauteil 20 zeigt einen ähnlichen Aufbau wie das Sensorbauteil 10, in Figur 2 jedoch ist die Linse 22 auf einen Glasfaser 51 ausgerichtet. Anstelle des Kameragehäuses 26 wie in Figur 2 ist über der Öffnung 44 der übergeordneten Schaltungsplatine 42 ein Glasfasereinsteckbereich 27 mit einem Glasfasereinstecksockel 48 angeordnet und auf der übergeordneten Schaltungsplatine 42 fixiert. Der Glasfasereinstecksockel 48 ist derart strukturiert, dass eine Einsteckhülse 49, die auf dem Glasfaser 51 befestigt und mit dem Glasfasereinstecksockel 48 in Eingriff bringbar ist. Der Glasfasereinstecksockel 48 ist derart ausgerichtet, dass die optischen Achsen 47 der Glasfaser 51 und die Linse 22 zueinander ausgerichtet sind.

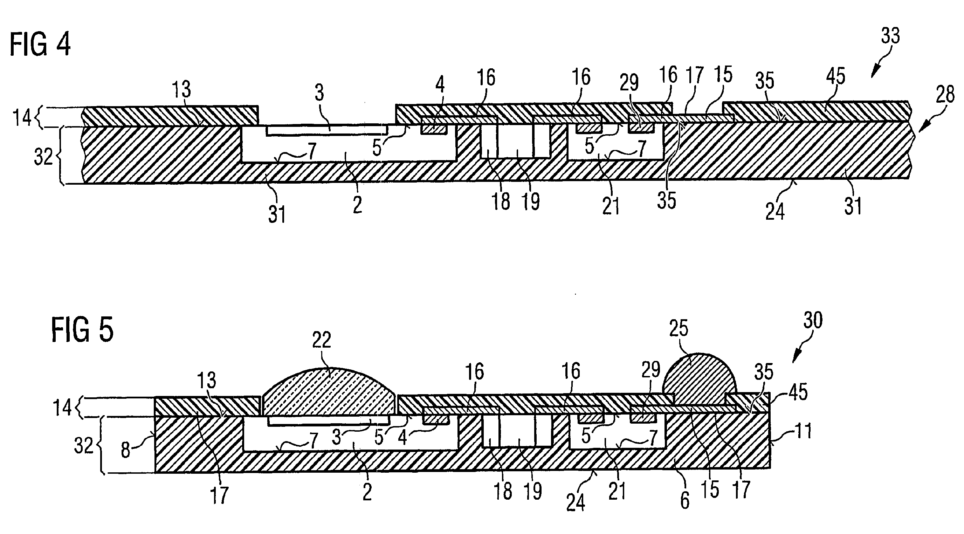

Figur 4 zeigt einen schematischen Querschnitt durch eine Sensorbauteilposition 33 eines Nutzens 28 vor dem Aufbringen von Außenkontakten und vor dem Auftrennen des Nutzens 28 in einzelne Sensorbauteile. Komponenten mit gleichen Funktionen wie in den vorhergehenden Figuren werden mit gleichen Bezugszeichen gekennzeichnet und nicht extra erörtert.

Der Nutzen 28 weist eine Verbundsplatte 32 mit einer Kunststoffplattenrückseite 24 auf. Die Verbundplatte 32 besteht aus einer Kunststoffmasse 31 und darin eingebetteten Sensorchips 2, Halbleiterchips 21 und passiven Bauelementen 19. Die Schaltungskomponenten 2, 19 und 21 sind derart in die Kunststoffmasse 31 der Verbundplatte 32 eingebettet, dass sie eine Gesamtoberseite 13 bilden, die mit einer Umverdrahtungslage 14 aus einer Umverdrahtungsschicht 15 mit Umverdrahtungsleitungen 16 bedeckt ist. Eine isolierende Abdeckung 45 lässt dann lediglich die Sensorbereiche 3 und die Außenkontaktflächen 17 in jeder der Bauteilpositionen 33 des Nutzens 28 frei.

Figur 5 zeigt einen schematischen Querschnitt durch ein Sensorbauteil 30 nach Aufbringen einer Linse 22 auf einen Sensorbereich 3 des Sensorbauteils 30 gemäß einer vierten Ausführungsform der Erfindung. Die Linse 22 und die Außenkontakte 25 für jedes der Sensorbauteile 30 kann entweder bereits auf den in Figur 4 gezeigten Nutzen in jeder der Bauteilpositionen aufgebracht werden oder nachträglich auf jedem einzelnen Sensorbauteil 30 fixiert werden. Die in Figur 5 gezeigte vierte Ausführungsform der Erfindung weist ausschließlich Außenkontakte 25 auf Außenkontaktflächen 17 auf, die über Umverdrahtungsleitungen 16 mit entsprechenden Elektroden der eingebetteten Schaltungskomponenten des Sensorbauteils 30 verbunden sind.

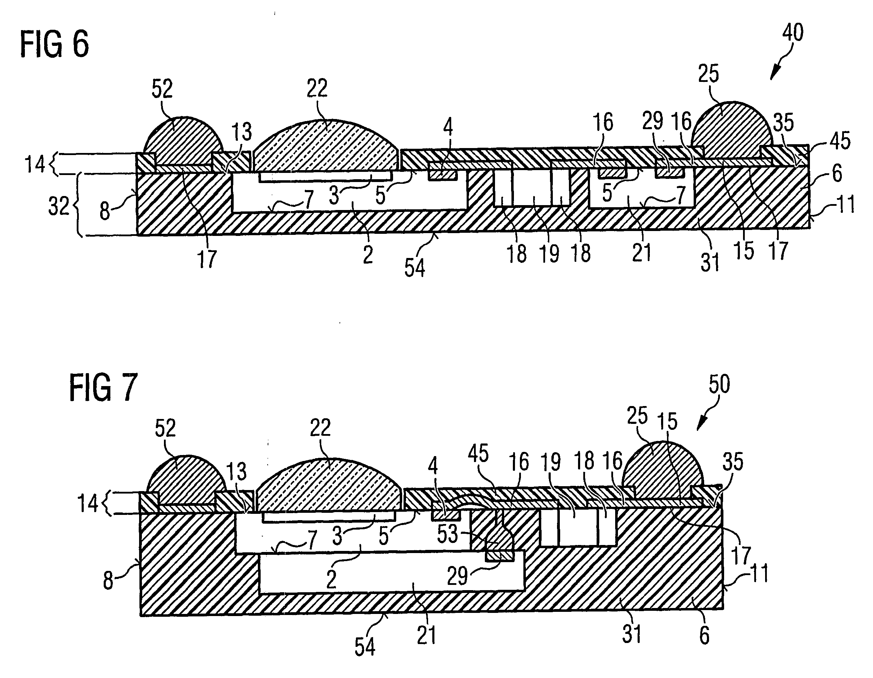

Figur 6 zeigt einen schematischen Querschnitt durch ein Sensorbauteil 40 einer fünften Ausführungsform der Erfindung. Komponenten mit gleichen Funktionen wie in den vorhergehenden Figuren werden mit gleichen Bezugszeichen gekennzeichnet und nicht extra erörtert.

Die fünfte Ausführungsform der Erfindung gemäß Figur 6 unterscheidet sich von der vierten Ausführungsform gemäß Figur 5 dadurch, dass zusätzlich zu Außenkontakten 25, die über Umverdrahtungsleitungen 16 mit den Elektrodenflächen 19 und Kontaktflächen 4 und 29 der Schaltungskomponenten 2,18 und 21 des Sensorbauteils verbunden sind, abstandshaltende Außenkontakte 52 auf der Gesamtoberseite angeordnet sind. Die Außenkontakte 52 sorgen beim Auflöten des Sensorbauteils 40 auf eine übergeordnete Schaltungsplatine dafür, dass ein ausreichender Abstand zwischen der Linse 22 und der darüber angeordneten Schaltungsplatine eingehalten wird. Auch in der fünften Ausführungsform der Erfindung sind die Schaltungskomponenten, wie Sensorchip 2, Halbleiterchip 21 und passive Bauelemente 19 derart angeordnet, dass jedes der Komponenten mit seinen Elektroden von der Gesamtoberseite 13 aus kontaktierbar ist.

Figur 7 zeigt einen schematischen Querschnitt durch ein Sensorbauteil 50 einer sechsten Ausführungsform der Erfindung. Diese sechste Ausführungsform der Erfindung unterscheidet sich von den vorhergehenden Ausführungsformen dadurch, dass der Halbleiterchip 21 und der Sensorchip 2 vor dem Einbetten in die Kunststoffmasse 31 aufeinander gestapelt sind. Bei der Stapelung wird darauf geachtet, dass die Kontaktflächen 29 nicht von dem Sensorchip 2 bedeckt sind, sondern dass die Kontaktflächen 29 mit Thermokompressionsköpfen 53 belegt werden können, die in ihrer Höhe der Dicke des Sensorchips 2 entsprechen. Somit ist auch der, unter dem Sensorchip 2 angeordnete Halbleiterchip 21, über die Gesamtoberseite 13 und die dort angeordnete Umverdrahtungsschicht 15 mit den übrigen Komponenten des Sensorbauteils 50 verbindbar.

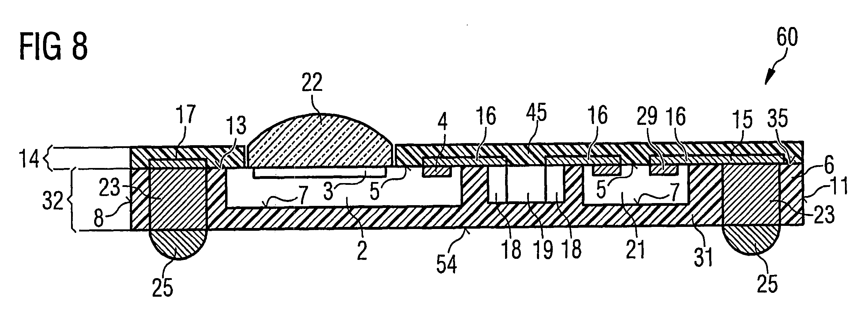

Figur 8 zeigt einen schematischen Querschnitt durch ein Sensorbauteil 60 gemäß einer siebten Ausführungsform der Erfindung. Die siebte Ausführungsform der Erfindung gemäß Figur 8 unterscheidet sich von den vorhergehenden Ausführungsformen dadurch, dass durch die Kunststoffmasse 31 Durchkontakte 23 vorgesehen werden, die in ihrer Länge der Dicke der Kunststoffplatte 6 entsprechen. Damit ist es möglich, auf der Rückseite 54 des Sensorbauteils 60 Außenkontakte 25 anzubringen, die dann gegenüberliegend zu der Linse 22 beziehungsweise zu dem Sensorbereich 3 des Sensorchips 2 angeordnet sind. Mit dieser siebten Ausführungsform der Erfindung ist es möglich, eine Oberflächenmontage auf einer übergeordneten Schaltungsplatine zu realisieren, wobei eine Öffnung in der übergeordneten Leiterplatte nicht erforderlich ist, da der Sensorbereich 3 des Sensorbauteils 60 trotz Oberflächenmontage auf einer übergeordneten Schaltungsplatine frei zugänglich ist.

## Patentansprüche

1. Sensorbauteil, das folgende Merkmale aufweist:
- einen Sensorchip (2) mit einem Sensorbereich (3), Elektroden des Sensorbereichs (3), Leiterbahnen und Kontaktflächen (4) auf einer aktiven Oberseite (5) des Sensorchips (2), wobei die Leiterbahnen die Kontaktflächen (4) mit den Elektroden elektrisch verbinden,
- eine Kunststoffplatte (6), in die der Sensorchip (2) mit seiner Rückseite (7) und seinen Randseiten (8-11) eingebettet ist, wobei die aktive Oberseite (5) des Sensorchips (2) einschließlich der Oberseiten der Kontaktflächen (4) mit der Oberseite (5) der Kunststoffplatte (6) eine plane Gesamtoberseite (13) bildet,
- eine auf der planen Gesamtoberseite (13) aufliegende Umverdrahtungslage mit einer Umverdrahtungsschicht (15), in der flache Umverdrahtungsleitungen (16) von den Kontaktflächen (4) zu Kontaktflächen (17, 18, 29) außerhalb des Sensorchips (2) ausgebildet sind.

2. Sensorbauteil nach Anspruch 1,
**dadurch gekennzeichnet, dass**
die Gesamtoberseite (13) Elektrodenflächen (18) von in die Kunststoffplatte (6) eingebetteten passiven Bauteilen (19) aufweist, wobei sich Umverdrahtungsleitungen (16) von den Elektrodenflächen zu Kontaktflächen (4) und/oder zu Außenkontaktflächen (17) erstrecken.

3. Sensorbauteil nach Anspruch 2,
**dadurch gekennzeichnet, dass**
die Gesamtoberseite (13) Kontaktflächen (29) von einem Halbleiterchip (21) mit integrierter Schaltung aufweist, wobei sich Umverdrahtungsleitungen (16) von den Kontaktflächen (29) des Halbleiterchips (21) zu Kontaktflächen (4) des Sensorchips (2) und/oder zu Elektrodenflächen (18) und/oder zu Außenkontaktflächen (17) erstrecken.

4. Sensorbauteil nach einem der vorhergehenden Ansprüche,
**dadurch gekennzeichnet, dass**
der Sensorchip (2) und ein Halbleiterchip (21) mit integrierter Schaltung übereinander gestapelt in der Kunststoffplatte (6) eingebettet sind, wobei der Sensorbereich (3) einen Teil der Gesamtoberseite (13) bildet.

5. Sensorbauteil nach einem der Ansprüchvorhergehenden Ansprüche,
**dadurch gekennzeichnet, dass**
der Sensorbereich (3) strahlungsempfindlich ist und eine Linse (22) aufweist.

6. Sensorbauteil nach einem der vorhergehenden Ansprüche,
**dadurch gekennzeichnet, dass**
die Kunststoffplatte (6) Durchkontakte (23) aufweist, wobei die Durchkontakte (23) auf einer Kunststoffplattenrückseite (24) mit Außenkontaktflächen (17) verbunden sind und mit den Umverdrahtungsleitungen (16) auf der Gesamtoberseite (13) elektrisch in Verbindung stehen.

7. Optoelektronisches Gerät, das ein Sensorbauteil (1) nach einem der vorhergehenden Ansprüche in einem Kameragehäuse (26) aufweist.

8. Optoelektronisches Kopplungsbauteil, das ein Sensorbauteil (1) nach einem der Ansprüche 1 bis 6 mit einem Glasfasereinsteckbereich (27) aufweist.

9. Nutzen, der in Zeilen und Spalten angeordnete Bauteilepositionen (33) mit Sensorbauteilen gemäß einem der Ansprüche 1 bis 6 aufweist.

10. Verfahren zur Herstellung eines Nutzens (28), das folgende Verfahrensschritte aufweist:
- Bereitstellen eines Halbleiterwafers mit in Zeilen und Spalten angeordneten Sensorchippositionen,
- Trennen des Halbleiterwafers in einzelne Sensorchips (2) mit einem Sensorbereich (3) und Kontaktflächen (4) auf einer aktiven Oberseite (5) der Sensorchips,
- Einlegen einer Klebefolie oder einer Klebeplatte in eine erste Moldwerkzeughälfte mit in Zeilen und Spalten angeordneten Bauteilpositionen (33),
- Aufbringen der Sensorchips (2) in den Bauteilpositionen unter Aufkleben der aktiven Oberseiten der Sensorchips auf die Klebeseite der Klebefolie oder der Klebeplatte,
- Zusammenfahren von Moldwerkzeughälften und Einspritzen einer Kunststoffmasse (31) in die Form unter einseitigem Einbetten der Sensorchips (2),
- Aushärten der Kunststoffmasse (31) zu einer Verbundplatte (32) aus Kunststoffmasse (31) mit Sensorchips (2),
- Entfernen der Klebefolie oder der Klebeplatte und Aufbringen einer Umverdrahtungslage (14) auf die freigewordene Gesamtoberseite (13) der Verbundplatte (32).

11. Verfahren nach Anspruch 10,
**dadurch gekennzeichnet, dass**
in Bauteilpositionen (33) zusätzlich passive Bauteile (19) mit ihren Elektrodenflächen (18) auf der Klebefolie oder auf der Klebeplatte positioniert werden.

12. Verfahren nach Anspruch 10 oder Anspruch 11,
**dadurch gekennzeichnet, dass**
in den Bauteilpositionen (33) zusätzlich Halbleiterchips (21) mit integrierten Schaltungen mit ihren Kontaktflächen (29) auf der Klebefolie oder auf der Klebeplatte positioniert werden.

13. Verfahren zur Herstellung eines Sensorbauteils, das folgende Verfahrensschritte aufweist
- Bereitstellen eines Nutzens (28) mit in Zeilen und Spalten angeordneten Bauteilpositionen (33), gemäß einem der Ansprüche 10 bis 12,
- Aufbringen von Außenkontakten (25) auf Außenkontaktflächen (17),
- Trennen des Nutzens (20) in einzelne Sensorbauteile (1,10,20,40,60).

## Claims

1. Sensor component having the following features:
- a sensor chip (2) with a sensor region (3), electrodes of the sensor region (3), conductor tracks and contact areas (4) on an active top side (5) of the sensor chip (2), the conductor tracks connecting the contact areas (4) to the electrodes,
- a plastic plate (6), in which the sensor chip (2) is embedded by its rear side (7) and its edge sides (8-11), the active top side (5) of the sensor chip (2), including the top sides of the contact areas (4), together with the top side (5) of the plastic plate (6) forming a planar overall top side (13),
- a rewiring stratum bearing on the planar overall top side (13) with a rewiring layer (15) in which flat rewiring lines (16) are formed from the contact areas (4) to contact areas (17, 18, 29) outside the sensor chip (2).

2. Sensor component according to Claim 1,
**characterized in that**
the overall top side (13) has electrode areas (18) of passive components (19) embedded in the plastic plate (6), rewiring lines (16) extending from the electrode areas to contact areas (4) and/or to external contact areas (17).

3. Sensor component according to Claim 2,
**characterized in that**
the overall top side (13) has contact areas (29) of a semiconductor chip (21) with integrated circuit, rewiring lines (16) extending from the contact areas (19) of the semiconductor chip (21) to contact areas (4) of the sensor chip (2) and/or to electrode areas (18) and/or to external contact areas (17).

4. Sensor component according to one of the preceding claims,
**characterized in that**
the sensor chip (2) and a semiconductor chip (21) with integrated circuit are embedded in a manner stacked one above the other in the plastic plate (6), the sensor region (3) forming a part of the overall top side (13).

5. Sensor component according to one of the preceding claims,
**characterized in that**
the sensor region (3) is radiation-sensitive and has a lens (22).

6. Sensor component according to one of the preceding claims,
**characterized in that**
the plastic plate (6) has through contacts (23), the through contacts (23) being connected to external contact areas (17) on a plastic plate rear side (24) and being electrically connected to the rewiring lines (16) on the overall top side (13).

7. Optoelectronic device, which has a sensor component (1) according to one of the preceding claims in a camera housing (26).

8. Optoelectronic coupling component, which has a sensor component (1) according to one of Claims 1 to 6, with an optical fibre plug-in region (27).

9. Panel, which has component positions (33) - arranged in rows and columns - with sensor components according to one of Claims 1 to 6.

10. Method for the production of a panel (28), which has the following method steps of:
- providing a semiconductor wafer having sensor chip positions arranged in rows and columns,
- separating the semiconductor wafer into individual sensor chips (2) with a sensor region (3) and contact areas (4) on an active top side (5) of the sensor chip,
- inserting an adhesive film or an adhesive plate into a first mould half with component positions (33) arranged in rows and columns,
- applying the sensor chips (2) in the component positions with adhesive bonding of the active top sides of the sensor chips on to the adhesive side of the adhesive film or of the adhesive plate,
- bringing together mould halves and injecting a plastics composition (31) into the mould with the sensor chips (2) being embedded on one side,
- curing the plastics composition (31) to form a composite plate (32) comprising plastics composition (31) with sensor chips (2),
- removing the adhesive film or the adhesive plate and applying a rewiring stratum (14) to the freed overall top side (13) of the composite plate (32).

11. Method according to Claim 10,
**characterized in that**
in component positions (33) passive components (19) are additionally positioned with their electrode areas (18) on the adhesive film or on the adhesive plate.

12. Method according to Claim 10 or claim 11,
**characterized in that**
in the component positions (33) semiconductor chips (21) with integrated circuits are additionally positioned with their contact areas (29) on the adhesive film or on the adhesive plate.

13. Method for the production of a sensor component, which has the following method steps of
- providing a panel (28) having component positions (33) arranged in rows and columns, according to one of the claims 10 to 12,
- applying external contacts (25) to external contact areas (17),
- separating the panel (20) into individual sensor components (1, 10, 20, 40, 60).

## Revendications

1. Composant de détection qui présente les caractéristiques suivantes :
- une puce de capteur (2) comprenant une zone de détection (3), les électrodes de la zone de détection (3), des pistes conductrices et des surfaces de contact (4) sur un côté supérieur actif (5) de la puce de capteur (2), les pistes conductrices reliant électriquement les surfaces de contact (4) avec les électrodes,
- une plaquette en matière plastique (6) dans laquelle est enrobée la puce de capteur (2) avec son côté arrière (7) et ses côtés latéraux (8-11), le côté supérieur actif (5) de la puce de capteur (2) ainsi que les côtés supérieurs des surfaces de contact (4) formant avec le côté supérieur (5) de la plaquette en matière plastique (6) un côté supérieur global plan (13),
- un niveau de câblage reposant sur le côté supérieur global plan (13) et comprenant un couche de câblage (15) dans laquelle sont formés des conducteurs de câblage plats (16) entre les surfaces de contact (4) et les surfaces de contact (17, 18, 29) à l'extérieur de la puce de capteur (2).

2. Composant de détection selon la revendication 1, **caractérisé en ce que** le côté supérieur global plan (13) présente des surfaces d'électrodes (18) de composants (19) passifs enrobés dans la plaquette en matière plastique (6), des lignes de câblage (16) s'étendant des surfaces d'électrodes aux surfaces de contact (4) et/ou aux surfaces de contact extérieures (17).

3. Composant de détection selon la revendication 2, **caractérisé en ce que** le côté supérieur global plan (13) présente des surfaces de contact (29) d'une puce en semiconducteur (21) avec circuit intégré, des lignes de câblage (16) s'étendant des surfaces de contact (29) de la puce en semiconducteur (21) aux surfaces de contact (4) de la puce de capteur (2) et/ou aux surfaces d'électrodes (18) et/ou aux surfaces de contact extérieures (17).

4. Composant de détection selon l'une des revendications précédentes, **caractérisé en ce que** la puce de capteur (2) et une puce en semiconducteur (21) avec circuit intégré sont enrobées dans la plaquette en matière plastique (6) empilées l'une au-dessus de l'autre, la zone de détection (3) formant une partie du côté supérieur global (13).

5. Composant de détection selon l'une des revendications précédentes, **caractérisé en ce que** la zone de détection (3) est sensible aux rayonnements et présente une lentille (22).

6. Composant de détection selon l'une des revendications précédentes, **caractérisé en ce que** la plaquette en matière plastique (6) présente des contacts traversants (23), les contacts traversants (23) étant reliés avec les surfaces de contact extérieures (17) sur un côté arrière de la plaquette en matière plastique (24) et étant en liaison électrique avec les conducteurs de câblage (16) sur le côté supérieur global (13).

7. Appareil optoélectronique qui présente dans un boîtier de caméra (26) un composant de détection (1) selon l'une des revendications précédentes.

8. Composant de couplage optoélectronique qui présente un composant de détection (1) selon l'une des revendications 1 à 6 avec une zone d'insertion de fibre de verre (27).

9. Flan qui présente des postes de composant (33) disposés en lignes et en colonnes comprenant des composants de détection selon l'une des revendications 1 à 6.

10. Procédé de fabrication d'un flan (28) qui présente les étapes suivantes:
- Fourniture d'une galette en semiconducteur comprenant des postes de puce de capteur disposés en lignes et en colonnes,
- Découpe de la galette en semiconducteur en puces de capteur (2) individuels comprenant une zone de détection (3) et des surfaces de contact (4) sur un côté supérieur actif (5) de la puce de capteur,
- Insertion d'un film autocollant ou d'une plaquette autocollante dans une première moitié d'outil de moulage avec des postes de composant (33) disposés en lignes et en colonnes,
- Application des puces de capteur (2) dans les postes de composant en collant les côtés supérieurs actifs de la puce de capteur sur le côté autocollant du fil autocollant ou de la plaquette autocollante,
- Assemblage des moitiés d'outil de moulage et injection d'une masse de matière plastique (31) dans le moule en enrobant d'un côté les puces de capteur (2),
- Durcissement de la masse de matière plastique (31) pour former une plaquette composite (32) constitué de la masse de matière plastique (31) avec les puces de capteur (2),
- Enlèvement du film autocollant ou de la plaquette autocollante et application d'un niveau de câblage (14) sur le côté supérieur global (13) libéré de la plaquette composite (32).

11. Procédé selon la revendication 10, **caractérisé en ce que** dans les positions de composant (33) sont en plus placés des composants passifs (19) avec leurs surfaces d'électrode (18) sur le film autocollant ou sur la plaquette autocollante.

12. Procédé selon la revendication 10 ou 11,
**caractérisé en ce que** dans les positions de composant (33) sont en plus placées des puces en semiconducteur (21) avec circuit intégré avec leurs surfaces de contact (29) sur le film autocollant ou sur la plaquette autocollante.

13. Procédé de fabrication d'un composant de détection qui présente les étapes suivantes :
- Fourniture d'un flan (28) qui présente des postes de composant (33) disposés en lignes et en colonnes selon l'une des revendications 10 à 12,
- Application de contacts extérieurs (25) sur les surfaces de contact extérieures (17),
- Découpe du flan (20) en composants de détection (1, 10, 20, 40, 60) individuels.
